(19) Europäisches Patentamt
European Patent Office
Office européen des brevets

(11) Publication number : **0 516 426 A1**

(12) # EUROPEAN PATENT APPLICATION

(21) Application number : **92304858.1**

(22) Date of filing : **28.05.92**

(51) Int. Cl.$^5$ : **G03F 7/039,** C08F 12/22

(30) Priority : **28.05.91 JP 152469/91**

(43) Date of publication of application :
**02.12.92 Bulletin 92/49**

(84) Designated Contracting States :
**DE FR GB**

(71) Applicant : **SHIN-ETSU CHEMICAL CO., LTD.**
**6-1, Ohtemachi 2-chome**
**Chiyoda-ku Tokyo (JP)**

(72) Inventor : **Yamada, Motoyuki**
**No. 259-404 Shimosakunobe, Takatsu-ku**
**Kawasaki-shi, Kanagawa-ken (JP)**
Inventor : **Furihata, Tomoyoshi**
**No. 2-18 Arima 9-chome, Miyamaye-ku**
**Kawasaki-shi, Kanagawa-ken (JP)**
Inventor : **Watanabe, Osamu**
**No. 50-406 Sanai-cho 4-chome**
**Jouetsu-shi, Niigata-ken (JP)**
Inventor : **Yagihashi, Fujio**
**Nr. 101, Aobadai Apt., No. 28-1 Aobadai**
**1-chome**
**Midori-ku, Yokohama-shi, Kanagawa-ken (JP)**

(74) Representative : **Stoner, Gerard Patrick et al**
**Mewburn Ellis 2 Cursitor Street**
**London EC4A 1BQ (GB)**

(54) **Resist compositions.**

(57) A resist based on a living polymer is provided. Living anionic polymerization of p-alloxycarbonyloxystyrene monomers results in polymers having a molecular weight distribution (Mw/Mn) of from 1 to 1.4.

EP 0 516 426 A1

Jouve, 18, rue Saint-Denis, 75001 PARIS

This invention relates to a resist composition for use in forming a fine pattern on the surface of semiconductor elements using ultra-violet or far ultraviolet light.

With the advance of LSI technology, thememory capacity of IC chips reaches an order of mega bits and a rule of submicron is thus required for the fineness of wiring pattern. Accordingly, lithography light sources are shifting toward shorter wavelength from the ultraviolet band to the far ultraviolet band which is more advantageous for fine patterning. Also, the current mainstream of etching step involved in the LSI manufacturing process is dry etching using RF plasma.

In these circumstances, the lithography technology uses resists which have to be sensitive and transmissive to the wavelength used and resistant against dry etching. More particularly, novolak type resins and other aromatic resins are useful resists for use in photolithography, especially G and I rays lithography in view of light transmittance at the wavelength used and plasma etching resistance.

However, the light source intensity of far ultraviolet light including mercury line spectrum on a shorter wavelength side than g and i line and excimer laser light such as KrF and ArF is extremely weaker than the light source intensity of g and i line. Utilization of such ultraviolet light in photolithography has the problem that prior art resists conventionally used with g and i line provide unacceptable exposure sensitivity and low light transmittance to far ultraviolet light. There is a need for a new type of resist.

Resists of the chemically amplified type were developed as a substitute for the conventional resists. For example, Japanese Patent Application Kokai (JP - A) No. 45439/1984 discloses a resist composition comprising p-tert-butoxycarbonyloxy-α-methylstyrene which is one of acid unstable polymers having recurring branched groups and a diaryl iodonium salt which is one of photopolymerization initiators capable of generating acid upon exposure to radiation. Upon exposure of the resist to far ultraviolet light, the diaryl iodonium salt decomposes to generate an acid which in turn, causes cleavage of the p-tert-butoxycarbonyl group of p-tert-butoxycarbonyloxy-α-methylstyrene into a polar group. Then a desired pattern is obtained by dissolving away the thus exposed areas or unexposed areas with base or non-polar solvent.

JP-A 115440/1987 discloses a resist composition comprising poly-4-tert-butoxy-α-styrene and di(tert-butylphenyl) iodonium trifluoromethane sulforonate which are dissolved in diglyme and then exposed to far ultraviolet light. This resist achieves a high degree of resolution through the same reaction mechanism as the resist of JP-A 45439/1984.

The polymers used in these well-known resists as a major component are obtained by conventional radical or cationic polymerization of corresponding monomers. Since no special attention was paid to the molecular weight distribution of polymers, there were obtained polymers having a broad and uneven molecular weight distribution. According to the inventors' investigations, if a resist based on a polymer having a broad molecular weight distribution is used, a low molecular weight moiety of the polymer can be gasified during the vacuum step involved in the wafer manufacturing process, resulting in a lowering of vacuum and contamination of the processing atmosphere. There always arises the problem that the polymer locally experiences a fast or slow dissolution rate due to uneven molecular weight distribution. As a result, an unstable state of patterning will often occur.

In order that the polymers obtained by conventional polymerization methods be used as resists, it was necessary to adjust the molecular weight distribution of the polymer after polymerization. Such post adjustment was cumbersome and impossible to effectively control the molecular weight. The conventional resist compositions were not regarded as suitable for the manufacture of high performance semiconductor elements like super LSI. There has been a desire to overcome these problems.

Therefore, an object of the present invention is to provide a novel and improved resist composition which has reduces the above-mentioned problems of the prior art and is useful for super LSI applications.

The inventors have found that living anionic polymerization of a monomer having rational formula (1):

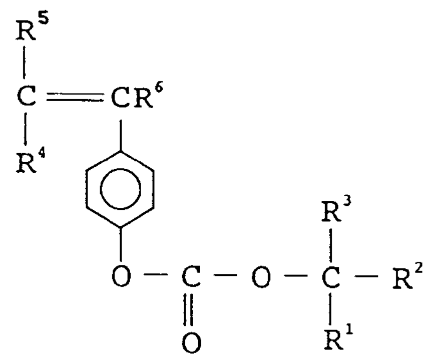

. . . (1)

wherein $R^1$ to $R^5$ are independently hydrogen or an alkyl group having 1 to 12 carbon atoms, and $R^6$ is hydrogen or a methyl group results in a living polymer having a narrow molecular weight distribution of from 1 to 1.4. The molecular weight distribution used herein is defined as the weight average molecular weight divided by the number average molecular weight, i.e., Mw/Mn. It is possible to control the molecular weight of the living polymer to a desired value. A resist based on such a polymer having a narrow molecular weight distribution can provide sufficient exposure sensitivity relative to ultraviolet and far ultraviolet light without a loss of light intensity and reduce the problems of the prior art including a lowering of vacuum during a vacuum step in wafer manufacturing process, contamination of the processing atmosphere, a varying polymer dissolving rate, and unstable patterning. The resist of the invention is thus adapted for the manufacture of super LSI.

FIG. 1 is a GPC elution curve of the polymer prepared in Preparation 1.

FIG. 2 is a GPC elution curve of the polymer prepared in Comparative Example.

The polymer which constitutes a predominant component of the resist according to the present invention is obtained by living anionic polymerization of a monomer having rational formula (1).

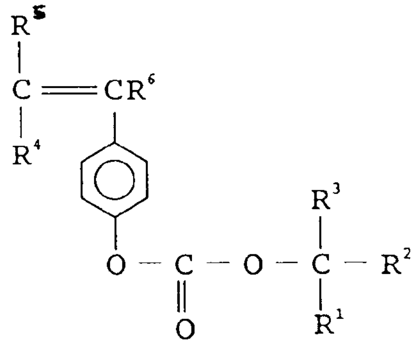

. . . (1)

In formula (1), $R^1$ to $R^5$ are independently selected from the group consisting of a hydrogen atom and an alkyl group having 1 to 12 carbon atoms. Exemplary alkyl groups include methyl, ethyl, propyl, butyl and pentyl groups, with alkyl groups having 1 to 3 carbon atoms being preferred. $R^6$ is a hydrogen atom or a methyl group.

Examples of the monomer of formula (1) include p-tert-butoxycarbonyloxystyrene, p-tert-butoxycarbonyloxy-α-methylstyrene, and p-triethylmethoxycarbonyloxystyrene, with the p-tert-butoxycarbonyloxystyrene being preferred because of ease of living polymerization.

The monomers may be used alone or in admixture of two or more. That is, the polymers may be homopolymers or copolymers.

Living polymerization of the monomer of formula (1) is often carried out by adding a polymerization initiator to the monomer in an organic solvent. Organometallic compounds are preferred initiators. Exemplary are organic alkali metals including n-butyllithium, sec-butyllithium, tert-butyllithium, sodium naphthalene, potassium naphthalene, sodium anthracene, disodium α-methylstyrene tetramer, cumylpotassium, and cumylcecium. The amount of polymerization initiator added may be determined through calculation from the desired molecular weight of a polymer to be produced and the moles of the starting monomer.

Examples of the organic solvent used include aromatic hydrocarbons such as cyclic ethers, and aliphatic hydrocarbons such as benzene, toluene, tetrahydrofuran, dioxane, tetrahydropyran, dimethoxyethane, n-hexane, and cyclohexane, alone or in admixture of two or more.

In living polymerization of monomers of rational formula (1), optimum reaction conditions including a living polymerization initiator and the concentration of monomer in organic solvent vary with a choice of a particular functional group in the monomer. A preliminary experiment is preferably carried out to predetermine optimum conditions. In general, monomers to be polymerized are present in organic solvents in concentrations of about 1 to 50% by weight, preferably about 5 to 20% by weight.

The monomers can be polymerized by stirring their organic solvent solution after the reaction system is evacuated to vacuum with or without subsequent purging of the atmosphere with inert gas such as argon and nitrogen. The reaction temperature may range from -100°C to room temperature. For example, a reaction temperature of -100°C is selected for tetrahydrofuran system and room temperature is selected for benzene system.

Living polymerization continuously proceeds since a carbanion does not attack ether oxygen at the para-position of a phenyl group and a vinyl group in the styrene moiety is selectively polymerized. Polymerization reaction is generally complete within about 10 minutes to about 5 hours. There are obtained polymers represented by formula (2).

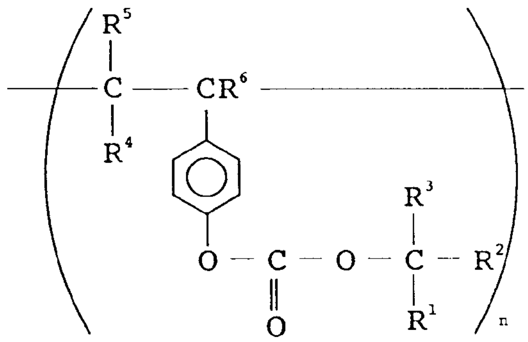

...(2)

(n is usually 30 to 50)

Thereafter, a stopper such as methanol, water, and methylbromide is added to the reaction solution to terminate the reaction. If necessary, the polymer is purified and isolated from the reaction solution by adding poor solvent such as methanol to the solution for causing the reaction product to precipitate, followed by washing and drying. Often, such purification is desirable because the polymer at the end of reaction generally contains unreacted reactants and by-products as impurities. If such a crude polymer is used as a resist in the manufacture of super LSI, the impurities can be detrimental to the wafer manufacturing process.

With respect to molecular weight distribution, the thus obtained polymers are mono-dispersed. Particularly, polymers having a narrow molecular weight distribution Mw/mn of from 1 to 1.4, especially from 1 to 1.2 are obtained. A Mw/Mn of more than 1.4 will offset the living polymerization effect so that an unstable state can occur during patterning due to low molecular weight polymer components.

There are obtained polymers in a yield of approximately 100% based on the monomers used. The molecular weight of a polymer can be readily calculated from the weight of a monomer used and the moles (or molecule number) of a polymerization initiator. The number average molecular weight (Mn) is determined through measurement by a membrane osmometer, the composition determined through infrared (IR) spectroscopy and $^1$H-NMR, and the molecular weight distribution determined by gel permeation chromatography (GPC), with which a polymer can be characterized to evaluate whether it is a desired one or not.

The resist composition of the invention contains the polymer as a predominant component, and it may further contain additional components, for example, photo-initiators and inert organic solvents. The photo-initiator is to generate strong acid upon exposure to light. In a wafer stepper, the photo-initiator in the exposed resist film is decomposed to generate strong acid which in turn, causes cleavage of a group of formula (3) in the living polymer into a group of formula (4).

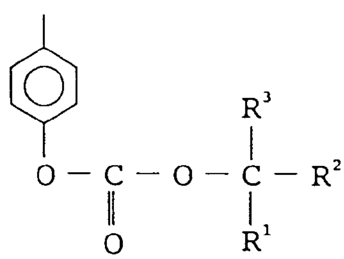

...(3)

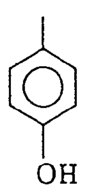

...(4)

As a result, the polymer is converted into an alkali soluble polymer.

Typical of the photo-initiator are onium salt cationic photo-initiators, examples of which are given below.

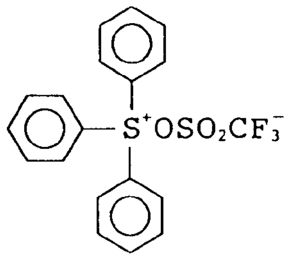

,

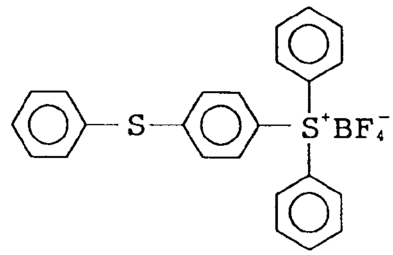

,

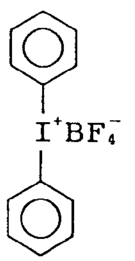

,

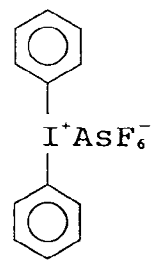

Other useful onium salt cationic photo-initiators are disclosed in JP-A 45439/1984, 115440/1987, and 300250/1989, and USP 4,537,854. The initiators are not limited to these examples and any substances capable of generating acid upon exposure to light may be used.

Preferably the photo-initiators are blended in amounts of about 0.01 to about 20% by weight, more preferably about 0.5 to about 5% by weight of the resist composition.

In practice, the resist is used in solution form by dissolving the resist in a several times large volume of organic solvent. A choice is made of the organic solvent in which the resist based on the living polymer according to the invention is well soluble and which allows a resist film to uniformly spread. Exemplary are butyl acetate, xylene, acetone, and cellosolve acetate, with the cellosolve acetate being most preferred. The organic solvents may be used alone or in admixture of two or more.

The use and light exposure of the resist may be in accord with the well-known conventional lithography. In particular, the resist of the invention is adapted for fine patterning with ultraviolet and far ultraviolet light having a wavelength of 254 to 193 nm.

There has been described a resist composition which contains as a predominant component a polymer having a controlled molecular weight and a narrow molecular weight distribution, which provides sufficient exposure sensitivity relative to ultraviolet and far ultraviolet light without a lowering of light intensity, and which reduces problems including a lowering of vacuum during a vacuum step in wafer manufacturing process, contamination of the processing atmosphere, a varying polymer dissolving rate, and unstable patterning. The invention thus provides a resist suited for the manufacture of super LSI.

## EXAMPLE

Examples of the present invention are given below by way of illustration and not by way of limitation. Before entering the examples, it is first described how to prepare a polymer.

### Preparation 1

The reactant used was p-tert-butoxycarbonyloxystyrene monomer which was pretreated with $CaH_2$, to remove water and impurities, refined with sodium benzophenone, and distilled. A 1-liter flask was charged with 600 ml of tetrahydrofuran solvent and $4 \times 10^{-3}$ mol of potassium naphthalene as a polymerization initiator. To the mixture was added 48 grams of the refined p-tert-butoxycarbonyloxystyrene monomer diluted with 100 ml of tetrahydrofuran at -78°C. Polymerization reaction took place for one hour whereupon the solution turned deep red. Polymerization was terminated by adding methanol to the reaction solution. The reaction solution was poured into methanol whereby the polymer was precipitated and thereafter, separated therefrom and purified. Drying yielded 48 grams of a white polymer.

FIG. 1 is the GPC elution curve of the polymer. The molecular weight distribution (Mw/Mn) was 1.19. By membrane osmometry, the number average molecular weight (Mn) of the polymer was measured to be $1.2 \times 10^4$ g/mol.

Preparation 2

The reactant used was p-tert-butoxycarbonyloxy-α-methylstyrene monomer which was dried and purified in the same manner as in Preparation 1. A 2-liter flask was charged with 1500 ml of tetrahydrofuran solvent and 4.5 X $10^{-3}$ mol of sec-butyllithium as a polymerization initiator. To the mixture was added 67.5 grams of the refined p-tert-butoxycarbonyloxy-α-methylstyrene monomer diluted with 200 ml of tetrahydrofuran at -78°C. Polymerization reaction took place for 4 hours whereupon the solution turned red. Polymerization was terminated by adding methanol to the reaction solution. The reaction solution was poured into methanol whereby the polymer was precipitated and thereafter, separated therefrom and purified. Drying yielded 67 grams of a white polymer. The molecular weight distribution (Mw/Mn) was 1.24. By membrane osmometry, the number average molecular weight (Mn) of the polymer was measured to be 1.5 X $10^4$ g/mol.

Examples 1 and 2

Polymer solutions were obtained by dissolving 2 grams of the polymers obtained in Preparations 1 and 2, respectively, in 12 ml of cellosolve acetate along with 0.15 grams of an onium salt represented by the following formula.

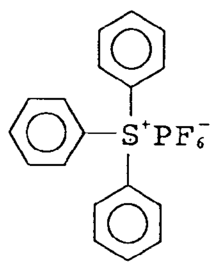

The polymer solutions were coated to one surface of silicon wafers by means of a spin coater and dried into polymer films of 1 μm thick. Using a stepper having built therein a light source for emitting light at a wavelength of 254 nm, the wafers were exposed to light, developed, and post-treated in a conventional manner. Both the polymer films had a line-and-space resolution of 0.4 μm.

Comparative Example

In a nitrogen purged vessel, a solution of 0.12 grams of 2,2-azobisisobutyronitrile and 5 grams of p-tert-butoxycarbonyloxystyrene monomer in 20 ml of toluene was subjected to polymerization reaction for 5 hours at 70°C. The resulting polymer was purified as in Preparation 1. The GPC elution curve of the polymer shown in FIG. 2 indicated a molecular weight distribution (Mw/Mn) of 2.98.

A polymer solution was obtained by dissolving 2.0 grams of the polymer in 12 ml of cellosolve acetate along with 0.15 grams of the same onium salt as in Example 1. As in Example 1, the polymer solution was coated and then exposed to light by means of the stepper. The patterns obtained on this polymer film were satisfactory at a width of up to 0.6 μm, but fine patterns of less than 0.6 μm showed overhangs. Some unresolved areas were observed.

Although some preferred embodiments have been described, many modifications and variations may be made thereto in the light of the above teachings. It is therefore to be under-stood that within the scope of the appended claims, the invention may be practiced otherwise than as specifically described.

## Claims

1. A resist composition comprising a polymer obtained by living anionic polymerization of a monomer having the rational formula (1):

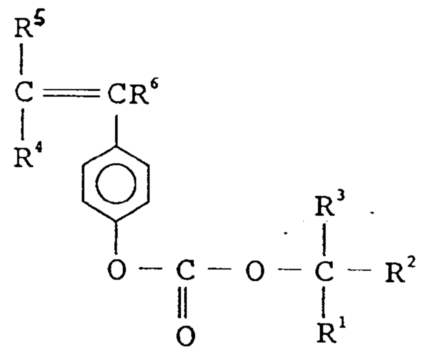

... (1)

wherein $R^1$ to $R^5$ are independently selected from the group consisting of hydrogen and alkyl groups having 1 to 12 carbon atoms, and $R^6$ is hydrogen or a methyl group, the polymer having a molecular weight distribution of from 1 to 1.4.

**2.** A resist composition according to claim 1 wherein the monomer is selected from p-tert-butoxycarbonyloxystyrene, p-tert-butoxycarbonyloxy-α-methylstyrene, and p-triethylmethoxycarbonyloxystyrene.

**3.** A resist composition according to claim 1 or claim 2 wherein the resist composition further comprises photo-initiators and/or inert organic solvents.

**4.** A resist composition according to claim 3 wherein the photo-initiator, if present, is blended in an amount of about 0.01% to about 20% by weight of the resist composition.

**5.** A method of manufacturing a resist composition according to any of claims 1 to 4 which comprises subjecting a monomer of formula (1) to a polymerization treatment.

**6.** A method according to claim 5 wherein the polymerization treatment is manipulated to obtain a polymer having a molecular weight distribution Mw/Mn of from 1 to 1.4.

**7.** A method according to claim 5 or 6 wherein the polymerization treatment is carried out in an organic solvent and in the presence of a polymerization initiator, and a stopper is added to terminate the reaction after a suitable time period.

**8.** A method according to claim 7 wherein the method further comprises purifying the polymer.

**9.** Use of a resist composition according to any of claims 1 to 4 in the manufacture of an integrated circuit or semi-conductor chip.

**10.** Use according to claim 9 wherein the manufacture of the chip involves photolithography utilizing UV light.

FIG.1

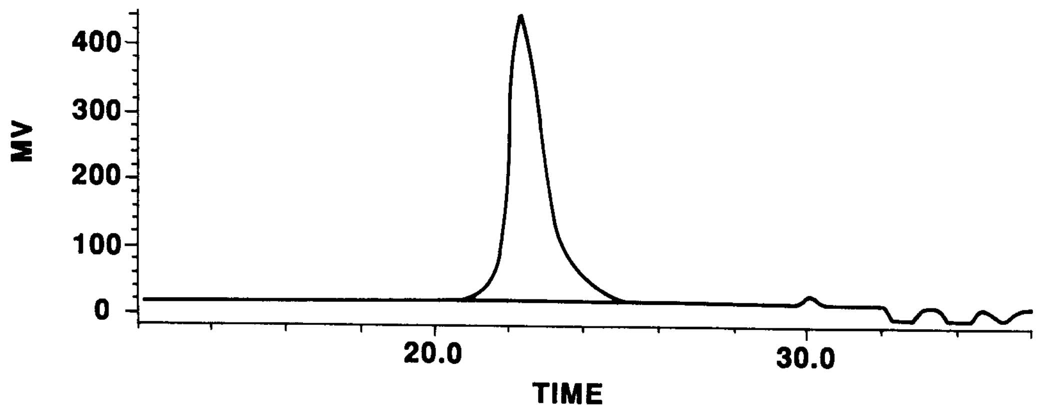


FIG.2

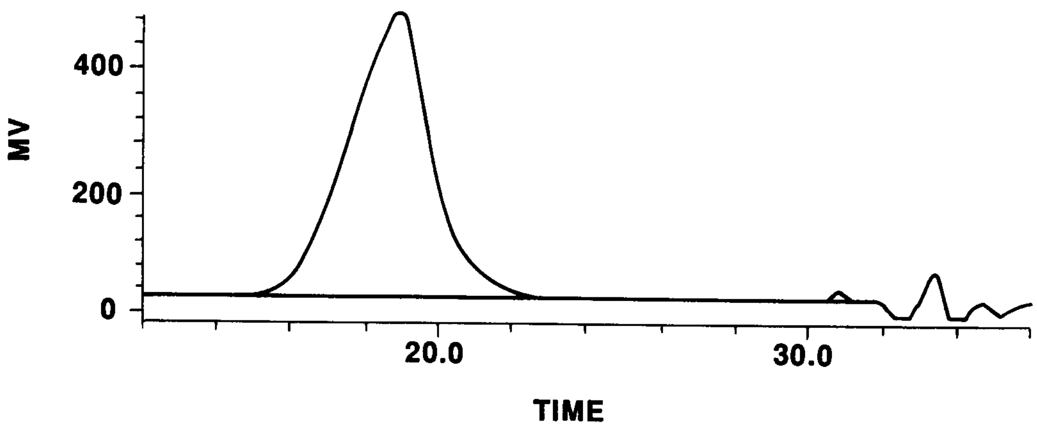

European Patent Office

# EUROPEAN SEARCH REPORT

Application Number

EP 92 30 4858

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y<br><br><br>D | EP-A-0 102 450 (INTERNATIONAL BUSINESS MACHINES CORP.)<br>* the whole document *<br>& JP-A-59 045 439 (...)<br>--- | 1-10 | G03F7/039<br>C08F12/22 |
| Y | FR-A-2 526 178 (TOYO SODA MANUFACTURING CO.)<br>* page 4, line 2 - line 4; example 1 *<br>--- | 1-10 | |
| A | CHEMICAL ABSTRACTS, vol. 105, no. 2, 14 July 1986, Columbus, Ohio, US;<br>abstract no. 6890Y,<br>S. NAKAHAMA: 'Anionic living polymerization of protected functional monomers'<br>* abstract *<br>& POLYM. PREPR. (AM. CHEM. SOC., DIV. POLYM. CHEM.)<br>vol. 27, no. 1, 1986,<br>pages 194 - 195;<br>--- | 1 | |
| A<br><br>D | US-A-4 603 101 (J.CRIVELLO)<br>* the whole document *<br>& JP-A-62 115 440 (...)<br>----- | 1-10 | TECHNICAL FIELDS SEARCHED (Int. Cl.5)<br>G03F |

The present search report has been drawn up for all claims

| Place of search | Date of completion of the search | Examiner |
|---|---|---|
| BERLIN | 04 SEPTEMBER 1992 | STOCK H. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)